# EUROPEAN PATENT SPECIFICATION

(11) **EP 1 568 260 B1**
(45) Date of publication and mention of the grant of the patent: **16.11.2011**
(21) Application number: 03812201.6
(22) Date of filing: 04.12.2003
(51) Int. Cl.: H05K 7/20, H01L 23/467

(54) **COOLING OF ELECTRIC APPLIANCE UNIT**
KÜHLUNG EINER ELEKTRISCHEN GERÄTEEINHEIT
SYSTEME DE REFROIDISSEMENT D'UNE UNITE POUR APPAREILS ELECTRIQUES

(30) Priority: 04.12.2002 FI 20022142
(43) Date of publication of application: 31.08.2005
(73) Proprietor: Schneider Electric Industries SAS, 92500 Rueil-Malmaison (FR)
(72) Inventor: KAIJÄRVI, Mikko, FIN-00200 Helsinki (FI); ÅBERG, Kari, FI-01510 Vantaa' (FI)
(74) Representative: Tanhua, Pekka Vilhelm
(86) International application number: PCT/FI2003/000931
(87) International publication number: WO 2004/052067

(56) References cited:
- EP-A1- 0 034 223
- US-A- 5 526 231
- PATENT ABSTRACTS OF JAPAN vol. 1998, no. 12 31 October 1998 & JP 10 020 081 A 31 July 1998
- PATENT ABSTRACTS OF JAPAN vol. 016, no. 204 (E-1202) 15 May 1992 & JP 04 032 299 A (FUJI ELECTRIC CO LTD) 04 February 1992

## Description

The invention relates to an electric appliance unit according to the preamble of claim 1, particularly to its cooling arrangement.

The electric appliance unit is meant to be installed in an electric control center or a corresponding electric board. By means of the electric appliance unit, there is managed and controlled particularly the electric current supply obtained from the power supply mains to for instance lighting fixtures, power sockets and to various electric machines and devices. The electric appliance unit can be for instance a switch unit, a measurement and/or control unit, such as a control unit of power/voltage or temperature. The electric appliance unit comprises a housing, inside which there are arranged electric and/or electronic components, such as relays, semiconductors, resistors etc. as well as their wiring and/or support structures, such as circuit boards. Most advantageously the electric appliance unit is fixed in a standard rail, i.e. a DIN rail or a similar support rail and/or support structure. Electric power is fed in the electric appliance unit, and control messages or corresponding information is transmitted from the appliance unit to the consumption point and/or to an electric appliance and/or device connected thereto.

In the prior art, there is known, from the patent application EP-0634768, a fuse unit, where at the top and bottom end of said housing there are arranged slots in order to enable the cooling air to flow in and respectively out. In the prior art there also is known, from the patent publication US-6 293 697, a housing for an HVAC-control unit provided with corresponding lower and upper ventilation openings. In general, the idea of arranging the cooling by means of slots or openings in a housing including electric appliances and/or components is know in the prior art.

A drawback in the above mentioned known air cooling arrangements is that the air circulation inside the housing are not controlled. The air that enters through the bottom part of the housing proceeds inside the housing as a rising air flow, conforming to and circulating around the various components or devices arranged therein, which means that the air flow also is slowed down by them.

In the prior art there is known from the publication JP-4032299A a cooler of an electric device, in which a waterproof housing for the device is equipped with several vertical cooling pipes passing through it. The pipes absorb heat from the inside of the housing. The air flow passing through the pipes cools them down and at the same time the inside of the housing.

Another drawback in known air cooling arrangements is that the air flow does not necessarily wash effectively exactly those components that produce a lot of waste heat. The provided cooling is a general of a type that is not even meant for the cooling of for high-power semiconductor components. For high-power semiconductor components, there are arranged specific cooling arrangements by means of suitable cooling fins, preferably on the outer surface of the housing and/or outside the housing.

The cooling required by currently known electric appliance units is realized in the way described above. This means that the separate cooling element of the high-power semiconductor component is arranged at the side of the housing, so that it is placed for instance between two electric appliance units. An additional problem is that the cooling element takes up space in the electric control center and particularly on the mounting rail, wherefore a maximum amount of electric appliance units cannot be fixed thereto.

In the prior art there is known, from the publication EP-0034223A, an air channel cooling for semiconductor devices. The cross-section of the air channel is variable so that it decreases in the direction of the air flow. The air channel is equipped with a fan. Several high-power semiconductor devices, comprising for example a hyristor and its cooling element, have been attached to the air channel. All semiconductor devices can be cooled in such a way that their operational temperatures are advantageously the same, although the air is warmer in the inlet end than in the outlet end of the channel. In this case essential for the cooling is thus the speed of the air flow, which is higher in the outlet end of the channel.

The drawbacks in the above described cooling arrangement are in principle the same as those of the cooling arrangements described above. In this case the air does not flow freely through the electric board or housing, but in a separate cooling channel whose cooling power is to be kept similar in every part of the channel by adjusting the transversal area in the air flow direction and the air flow in the channel. The semiconductor devices have been attached to the channel with its actual cooling fins. It must be noticed that the presented measures of the channel are relatively large, such as 250 x 270 mm² in the inlet end of the channel, which means that the cooling channel takes up space that is particularly suited in connection with an electric board or the like.

The publication JP-10200281 A shows a forcible air cooling radiator body with power transistors mounted in close contact with its outer surface; a fan is mounted in one opening of the body, and the other opening is connected to an opening of a back surface panel.

The object of the invention is to eliminate the drawbacks connected to the above described known cooling arrangements. Another object of the invention is to realize a new cooling arrangement for an electric appliance unit.

The cooling arrangement of an electric appliance unit according to the invention is characterized by what is set forth in claim 1. The independent claim represents preferred embodiments of the invention.

The invention relates to a cooling arrangement for an electric appliance unit that comprises a housing, inside which housing there are arranged electric and/or electronic components, such as relays, semiconductors, resistors, as well as their wiring and support structures, which cooling arrangements comprises a vertical cooling channel arranged through the housing, through which cooling channel the cooling air is arranged to flow, and in connection with which cooling channel there is installed at least one device, device element or component, such as a high-power semiconductor, that has a high cooling demand. In accordance with the invention the casing of the cooling channel is a pipe, most preferably a straight pipe, so that the cooling channel is formed of the elongate space left inside the casing and the component to be cooled, such as a high-power semiconductor, is directly attached to the cooling channel casing.

In the most preferred embodiment of the invention, the cooling channel casing is made of a highly heat-conductive metal, such as copper or aluminum. In addition, it is preferable that the component to be cooled, such as a high-power semiconductor, is directly attached to the cooling channel casing. In that case the heat transfer from the heat source to the cooling channel and further to the air flow is most effective.

In a preferred embodiment of the invention the cross-section of the cooling channel is most preferably round, ellipsoidal or a polygon. This form and the cross-section secure that the air flow through the cooling channel takes place at a maximal efficiency without disturbances.

An advantage of the invention is that the cooling arrangement is simple in structure, fairly small in size and light in weight. Now, its needs little space and is easy to install. Hence it is an economical cooling arrangement. In addition, it is an efficient cooler. The cooling arrangement according to the invention is particularly suited for cool small devices without structures or components which accelerate the air flow. Another advantage of the invention is that electric appliance units that are provided with a cooling arrangement according to the invention can be placed compactly side by side in the electric control center.

The invention is described in more detail below with reference to the appended drawing, where
figure 1 is a schematical perspective illustration of an electric appliance unit according to the invention, fixed in a mounting rail;
figure 2 is a schematical front-view illustration of a number of adjacently installed electric appliance units according to the invention;
figure 3 is a vertical cross-section along the line C - C of the electric appliance unit illustrated in figure 1;
figure 4 is a transversal section along the line D - D of the electric appliance unit illustrated in figure 1;
figure 5 is a cross-section of the cooling channel of another electric appliance unit;
figure 6 is a partial vertical cross-section of the cooling channel illustrated in figure 5;
figure 7 is a transversal section of a third cooling channel of an electric appliance unit;
figure 8 is a front-view illustration of the cooling channel of figure 7; and
figure 9 is a transversal section of a fourth cooling channel of an electric appliance unit.

Like numbers for like parts are used in the drawings.

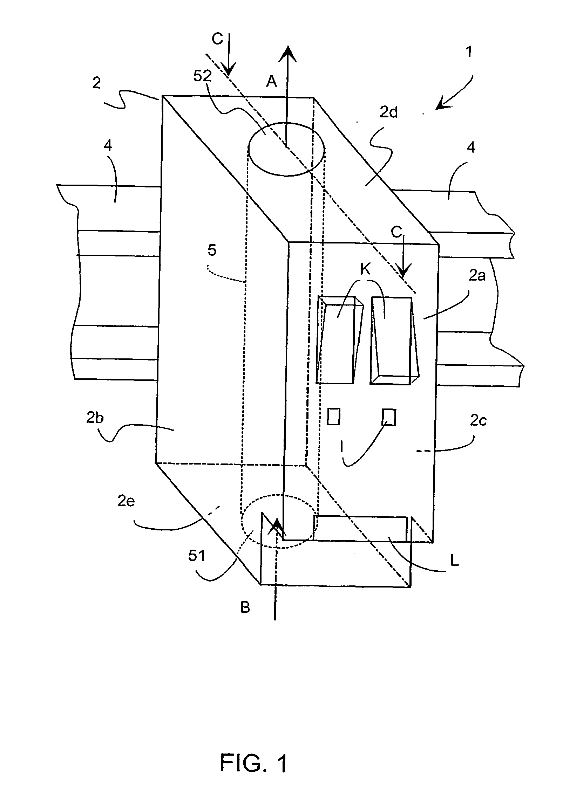

An electric appliance unit 1 according to the invention is illustrated in figure 1 as installed on the mounting rail 4, such as DIN rail, of an electric board arrangement (not illustrated). The electric appliance unit 1 comprises a housing 2, which advantageously has the shape of a regular rectangular prism. At the front part 2a of the housing, there is generally provided at least one of the following elements: at least one connector L, a switch K and/or an indicator light I. In this preferred embodiment, the side parts 2b, 2c of the housing are essentially straight, parallel plates and have the shape of a polygon modified of a rectangle. The top part 2d and respectively bottom part 2e of the housing connect the side plates 2b, 2c together. The fastening elements 3 are arranged in the back part 2f of the housing in order to attach the electric appliance unit 1 to the underlay, in this case to the mounting rail 4.

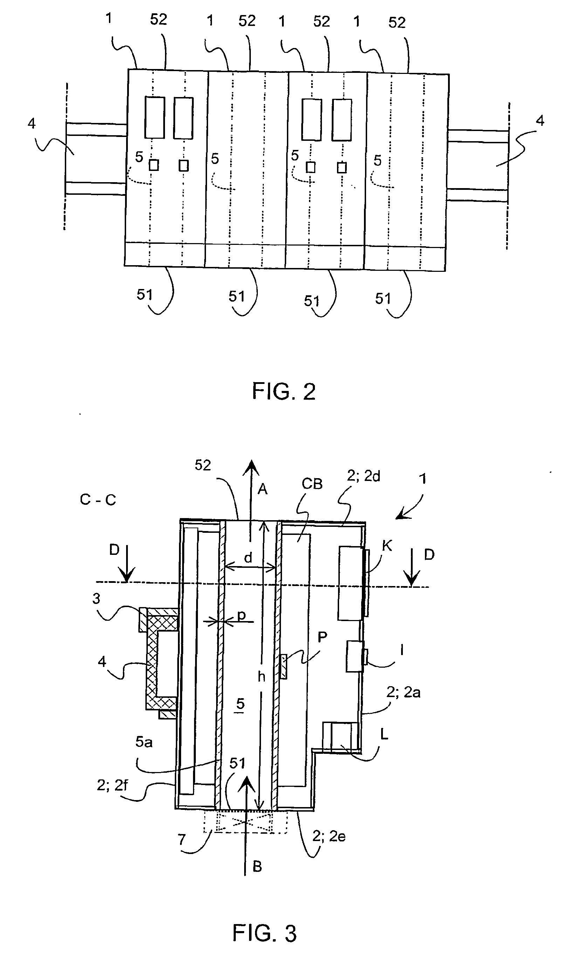

Inside the housing 2 of the electric appliance unit 1, there are arranged electric and/or electronic components, such as relays, semiconductors, resistors, as well as their wiring and support structures, such as circuit boards CB. With suitable fastening elements 3, the electric appliance unit 1 can be attached to an electric control center or to a corresponding electric board. Preferably the electric appliance units 1 connected to the control arrangements of lighting a certain facility, and/or generally to the control arrangements of electric appliances and/or devices, are attached mutually adjacently on the mounting rail 4 in a suitable electric control center, as illustrated in figure 2.

According to the invention, a vertical cooling channel 5 is provided through the housing 2, through the top and bottom parts 2d, 2e thereof. Now, the inlet 51 of the cooling channel 5 is arranged to pass through the bottom part 2d of the housing, and respectively the outlet 52 is arranged to pass through the top part 2e of the housing. Through said channel 5, the cooling air flows from bottom to top, as is illustrated in figures 1 and 3 by arrows A, B, through the electric appliance unit 1. In connection with the cooling channel 5, there is installed at least one device with a high cooling demand, or an element or component of such a device, for instance a high-power semiconductor P, such as a tyristor, a triac or a high-power channel transistor, such as MOSFET. In connection with one cooling channel 5, there can naturally be arranged several components or the like to be cooled, providing that the cooling power of the cooling channel is sufficient.

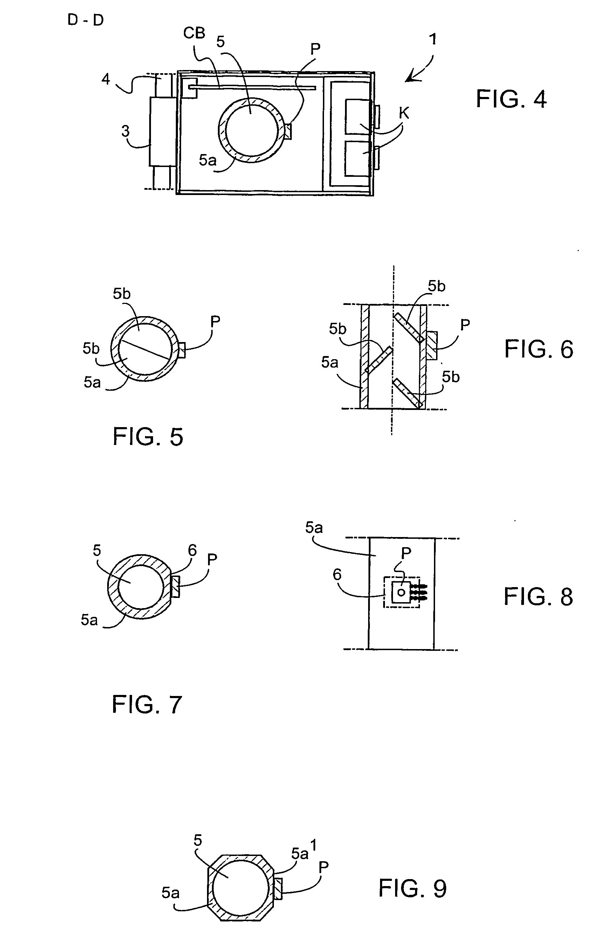

The cooling channel casing 5a is a pipe. Thus the cooling channel 5 is formed of the elongate space left inside the casing 5a. Preferably the casing 5a is a straight pipe, but it can also be slightly curved. In cross-section, the cooling channel 5 and at the same time the inner surface of the casing 5a is advantageously round, as is illustrated for instance in figure 4, or ellipsoidal. In general, the casing 5a may in that case be a curved, enclosed surface, or an enclosed combination of curved surfaces. In cross-section, the outer surface of the casing 5a is advantageously similar as the inner surface, which means that the thickness p of the casing is constant. As an alternative, the outer surface of the casing 5a can also be different in cross-section than the inner surface, in which case the thickness of the casing on the cross-sectional plane fluctuates.

As an alternative, the cross-section of the cooling channel 5 and at the same time of the inner surface of the casing 5a is a polygon, such as a rectangle or a square. The outer surface of the casing 5a is in cross-section advantageously similar as the inner surface, but it may also be different, as was the case in the former embodiment.

The measures of the cooling channel 5, particularly its diameter d and casing thickness p, can be designed according to the cooling demand of the electric appliance unit and the devices and/or components contained therein. Preferably the diameter d of the cooling channel 5 is within the range 10 - 30 mm, but it may also be larger, depending on the size of the electric appliance unit. The thickness d of the casing 5a is for instance within the range 1 - 5 mm, but other thickness measures may also be applied, depending on the application in question. Moreover, it is possible to arrange, in one electric appliance unit, two or even more cooling channels adjacently, either in direct mutual contact or at a small distance from each other. The height h of the cooling channel 5 is of the order 50 - 150 mm, but it depends on the height of the electric appliance unit 1, because it is preferably of the same size with it.

In the most preferred embodiment of the invention, the casing 5a of the cooling channel 5 is made of a highly heat-conductive metal, such as copper or aluminum. However, it should be appreciated that some other highly heat-conductive material, for example a suitable plastic, may be considered.

The heat-producing components P and/or devices of the electric appliance unit 1 should be placed on the outer surface of the cooling channel casing 5a, and at the same time outside the cooling channel 5 proper, whereas the inner surface of the casing, which inner surface opens into the cooling channel, serves as a heat-emitting surface. When the cooling channel casing 5a is heated as the operating components or devices emit waste heat therein, the air contained in the cooling channel 5 also is heated and rises up through the cooling channel and is discharged through the top part, via the outlet 52 (arrow A); now fresh, cool air flows into the cooling channel from the bottom part, through the inlet 51 (arrow B). Thus the cooling channel casing 5a is cooled down and at the same time it cools the heat-producing component and/or device.

In principle, air must flow through the cooling channel 5 as freely as possible. In that case the cooling channel 5 is an open pipe, and the inner surface 5a of the pipe casing is most advantageously smooth. As an alternative, the inner surface of the casing 5a is coarse, in which case the cooling area is expanded, and heat transfer becomes more effective.

In a preferred embodiment of the invention, in the inner cooling channel 5, particularly in the inner wall of the cooling channel casing 5a, there are arranged brackets 5b, such as fins or orientation elements, for example blade-like elements, as is illustrated in figures 5 and 6. These brackets 5b affect the air flowing through the cooling channel 5 and set it in a turbulent and/or spiraling motion. The brackets 5b enlarge the heat transfer surface of the cooling channel 5 and thus they also enhance the heat transfer from the cooling channel casing 5a to the air flow.

In the invention, in the casing 5a of the cooling channel 5, particularly in the outer surface of the casing, there is directly attached the device or component to be cooled, such as one or several high-power semiconductor components P. For this purpose it is advantageous that in the outer surface of the casing 5a there is arranged a platform, i.e. an even, straight area 6, particularly in cases where the cross-section of the outer surface of the casing 5a is round or ellipsoidal, as is illustrated in figures 7 and 8. The component or the like to be cooled is attached onto the platform 6, against the casing 5a. The platform 6 makes it easier to fasten the components and enhances heat transfer between the component P and the cooling channel 5.

In another preferred embodiment of the invention, the casing 5a of the cooling channel 5 is at least on its outer surface polygonal in cross-section, as is illustrated in figure 9. The advantage with this kind of cooling channel casing is that a high-power semiconductor component P or a corresponding device can be fitted in against one side wall 5a¹ of the polygon forming the casing. Thus the junction surface of the casing 5a between the heat-producing device and the cooling channel casing is direct and immediate, for example when using the platform 6, so that the heat is effectively transferred from the device to the cooling channel and further to the air flow.

In a preferred embodiment of the invention, in connection with the cooling channel 5 there is connected a fan 7 (illustrated by dotted lines in figure 3), such as an electrically operated axial fan. Most advantageously the fan 7 is arranged in connection with the inlet 51 of the cooling channel 5. The fan 7 forces air through the inlet 51 to the cooling channel 5 and further out through the outlet 52. Consequently, by means of the fan 7, the flowing of air through the cooling channel is made more effective, and the cooling power is raised with respect to the arrangements described above. It must be noticed that the fan is not a compulsory or essential component for the invention, but the cooling arrangement works well and with sufficient power also without it

The invention is not restricted to the above described preferred embodiments only, but many modifications are possible within the scope of the inventive idea defined in the claims.

## Claims

1. A cooling arrangement for an electric appliance unit, said electric appliance unit (1) comprising a housing (2), inside which there are arranged electric and/or electronic components, such as relays, semiconductors and resistors, as well as their wiring and support structures, which cooling arrangement comprises a vertical cooling channel (5) fitted through the housing (2), through which cooling channel (5) the cooling air is arranged to flow (A, B), and in connection with said cooling channel, there is installed at least one device, device element or component with a high cooling demand, such as a high-power semiconductor (P), the casing (5a) of the cooling channel (5) is a pipe, preferably a straight pipe, and the cooling channel (5) is formed of the elongate space left inside the casing (5a) and to the casing (5a) of the cooling channel (5), there is directly attached a component to be cooled, such as a high-power semiconductor (P).

2. An electric appliance unit according to claim 1, **characterized in that** in the cooling channel (5), particularly on the inner wall of the casing (5a) thereof, there are provided brackets (5b).

3. An electric appliance unit according to any of the preceding claims, **characterized in that** the casing (5a) of the cooling channel (5) is formed of a highly heat-conductive metal, such as copper or aluminum.

4. An electric appliance unit according to any of the preceding claims, **characterized in that** the casing (5a) of the cooling channel (5) is a curved, enclosed surface, in cross-section most advantageously a circle or an ellipse.

5. An electric appliance unit according to any of the preceding claims 1 - 3 **characterized in that** the casing (5a) of the cooling channel (5) is at least on the outer surface polygonal in cross-section.

6. An electric appliance unit according to claim 4, **characterized in that** on the outer surface of the casing (5a) of the cooling channel (5), there is arranged a platform (6), on which the component (P) to be cooled is attached.

7. An electric appliance unit according to any of the preceding claims, **characterized in that** in connection with the cooling channel (5), there is provided a fan (7).

## Patentansprüche

1. Kühlanordnung für eine Elektrogerät-Einheit, wobei die Elektrogerät-Einheit (1) ein Gehäuse (2) umfasst, innerhalb von welchem sowohl elektrische oder/und elektronische Komponenten angeordnet sind, wie beispielsweise Relais, Halbleiter und Widerstände, als auch deren Verkabelung und Haltestrukturen, wobei die Kühlanordnung einen vertikalen Kühlkanal (5) umfasst, der durch das Gehäuse (2) verlaufend angebracht ist, wobei es eingerichtet ist, dass die Kühlluft durch diesen Kühlkanal (5) strömt (A, B), und wobei in Verbindung mit dem Kühlkanal wenigstens eine Einrichtung, ein Einrichtungselement oder eine Komponente mit einem hohen Kühlbedarf installiert ist, wie beispielsweise ein Hochleistungshalbleiter (P), wobei das Gehäuse (5a) des Kühlkanals (5) ein Rohr ist, bevorzugt ein gerades Rohr, und wobei der Kühlkanal (5) durch den innerhalb des Gehäuses (5a) bleibenden länglichen Raum gebildet ist, und wobei an dem Gehäuse (5a) des Kühlkanals (5) direkt eine zu kühlende Komponente angebracht ist, wie beispielsweise ein Hochleistungshalbleiter (P).

2. Elektrogerät-Einheit nach Anspruch 1,
**dadurch gekennzeichnet, dass** in dem Kühlkanal (5), insbesondere an der Innenwand des Gehäuses (5a) davon, Ausleger (5b) vorgesehen sind.

3. Elektrogerät-Einheit nach einem der vorhergehenden Ansprüche,
**dadurch gekennzeichnet, dass** das Gehäuse (5a) von dem Kühlkanal (5) aus einem stark wärmeleitenden Metall gebildet ist, wie beispielsweise Kupfer oder Aluminium.

4. Elektrogerät-Einheit nach einem der vorhergehenden Ansprüche,
**dadurch gekennzeichnet, dass** das Gehäuse (5a) von dem Kühlkanal (5) eine gekrümmte geschlossene Fläche ist, im Querschnitt am vorteilhaftesten ein Kreis oder eine Ellipse.

5. Elektrogerät-Einheit nach einem der vorhergehenden Ansprüche 1 bis 3, **dadurch gekennzeichnet, dass** das Gehäuse (5a) von dem Kühlkanal (5) im Querschnitt wenigstens an der Außenfläche polygonal ist.

6. Elektrogerät-Einheit nach Anspruch 4,
**dadurch gekennzeichnet, dass** an der Außenfläche des Gehäuses (5a) des Kühlkanals (5) eine Plattform (6) angeordnet ist, an welcher die zu kühlende Komponente (P) angebracht ist.

7. Elektrogerät-Einheit nach einem der vorhergehenden Ansprüche,
**dadurch gekennzeichnet, dass** in Verbindung mit dem Kühlkanal (5) ein Lüfter (7) vorgesehen ist.

## Revendications

1. Système de refroidissement pour appareil électrique, ledit appareil électrique (1) comprenant un boîtier (2) à l'intérieur duquel sont disposés des composants électriques et/ou électroniques tels que des relais, des semi-conducteurs et des résistances, ainsi que leurs câblages et structures de support, lequel système de refroidissement comprend un conduit vertical de refroidissement (5) traversant le boîtier (2), conduit de refroidissement (5) dans lequel est amené à s'écouler (A, B) l'air de refroidissement, et en liaison avec ledit conduit de refroidissement est installé au moins un dispositif, élément de dispositif ou composant nécessitant un grand refroidissement, tel qu'un semi-conducteur (P) de forte puissance, l'enveloppe (5a) du conduit de refroidissement (5) étant un tube, de préférence un tube rectiligne, et le conduit de refroidissement (5) étant constitué par l'espace allongé laissé à l'intérieur de l'enveloppe (5a) et, un composant à refroidir tel qu'un semi-conducteur (P) de forte puissance étant directement fixé à l'enveloppe (5a) du conduit de refroidissement (5)

2. Appareil électrique selon la revendication 1, **caractérisé en ce que** des supports (5b) sont présents dans le conduit de refroidissement (5), en particulier sur la paroi intérieure de l'enveloppe (5a) de celui-ci.

3. Appareil électrique selon l'une quelconque des revendications précédentes, **caractérisé en ce que** l'enveloppe (5a) du conduit de refroidissement (5) est en métal très conducteur de la chaleur, tel que le cuivre ou l'aluminium.

4. Appareil électrique selon l'une quelconque des revendications précédentes, **caractérisé en ce que** l'enveloppe (5a) du conduit de refroidissement (5) est une surface courbe, close, à section transversale avantageusement circulaire ou elliptique.

5. Appareil électrique selon l'une quelconque des revendications précédentes 1 à 3, **caractérisé en ce que** l'enveloppe (5a) du conduit de refroidissement (5) a, au moins sur la surface extérieure, une section transversale polygonale.

6. Appareil électrique selon la revendication 4, **caractérisé en ce que** sur la surface extérieure de l'enveloppe (5a) du conduit de refroidissement (5) est disposée une plate-forme (6) sur laquelle est fixé le composant (P) à refroidir.

7. Appareil électrique selon l'une quelconque des revendications précédentes, **caractérisé en ce qu'**un ventilateur (7) est prévu en liaison avec le conduit de refroidissement (5).
